# EUROPEAN PATENT SPECIFICATION

(11) **EP 1 736 518 B1**
(45) Date of publication and mention of the grant of the patent: **07.05.2008**
(21) Application number: 06012686.9
(22) Date of filing: 20.06.2006
(51) Int. Cl.: C09J 9/02, C08K 5/098, C08K 3/08, C09J 11/06

(54) **Use of metal salts of organic acids as conductivity promoters**
Verwendung von Metallsalzen organischer Säuren als Leitfähigkeitsförderer
Utilisation des sels métalliques d'acides organiques comme promoteurs de la conductivité

(30) Priority: 23.06.2005 US 166860
(43) Date of publication of application: 27.12.2006
(73) Proprietor: National Starch and Chemical Investment Holding Corporation, New Castle, Delaware 19720 (US)
(72) Inventor: Emmerson, Gordon T., Seal Beach California 90740 (US); Kuder, Harry Richard, Fullerton California 92833-2339 (US); Musa, Osama M., Hillsborough New Jersey 08844 (US)
(74) Representative: Held, Stephan

(56) References cited:
- EP-A- 1 174 462
- US-A1- 2005 075 428

## Description

### RELATED APPLICATION

This application is related to US serial number ****** entitled "Silver Salts of Dicarboxcylic Acids For Precious Metal Powder and Flakes" filed on 23 June 2005.

### FIELD OF THE INVENTION

This invention relates to the use of metal salts of organic acids in conductive resin compositions.

### BACKGROUND OF THE INVENTION

Conductive fillers are added to resin compositions in order to make them either thermally or electrically conductive. Conductive resins compositions have a wide variety of uses, such as, replacement for solder, for example, in attaching a circuit component to a circuit board or a semiconductor die to a leadframe; shielding, for example, as a conductive coating to cany away stray current or static electricity; conductive ink, for example, as a polymer thick film ink or an RFID ink for a conductive antenna; tantalum capacitor; or thermal interface material, for example, as a silicon gel or grease for heat dissipation.

In particular, conductive resins can be used as adhesives for attaching semiconductor dies or chips to a substrate. For some uses, those that require a high level of electrical conductivity between the die and the substrate, for example in a power integrated circuit or as a replacement for solder, enhanced conductivity is necessary. The obvious method for doing this is to increase the loading of the conductive filler in the resin composition or to utilize a more conductive filler. Either of these methods, however, may affect the rheology or other performance characteristics of the composition.

EP1174462 discloses an electrically conductive silicone adhesive comprising electrically conductive particles and metal salts of carboxylic acids.

This document teaches the use of metal salts of carboxylic acids as condensation catalysts and not as conductivity promoters in a conductive resin composition comprising resin and a conductive filler.

### SUMMARY OF THE INVENTION

The inventors have discovered that the addition of a metal salt of an organic acid to a conductive resin composition comprising a resin and a conductive filler, improves the conductivity of the composition, particularly its electrical conductivity, without detriment to worklife or rheology. The improved conductive resin composition is thus commercially suitable for applications within the semiconductor packaging industry, and especially for applications that require a high level of electrical conductivity.

### DETAILED DESCRIPTION OF THE INVENTION

This invention is the use of a metal salt of an organic acid, excluding the metal salts of acrylic or methacrylic acids in a conductive resin composition comprising a resin and a conductive filler. The addition of the metal salt to the composition improves conductivity significantly. In this embodiment, the metal salt is activated by heat generated from the operation of the device in which the conductive resin composition is utilized.

In one embodiment the composition comprises a curable resin and a curing agent for the resin, a conductive filler, and a metal salt of an organic acid excluding the metal salts of acrylic or methacrylic acids. This technology can be used in chemistries that cure via condensation, addition, and electron donor/electron acceptor reactions. In this embodiment, the metal salt is activated by the heat of reaction or by the input of heat to initiate the reaction.

The metal salts suitable for use in the inventive conductive resin compositions are the metal salts of organic acids, and may be either mono-functional or poly-functional, that is, the metal element may have a valence of one, or a valence of greater than one. The metal elements suitable for coordination in the salts include lithium (Li), sodium (Na), magnesium (Mg), potassium (K), calcium (Ca), scandium (Sc), titanium (Ti), vanadium (V), chromium (Cr), manganese (Mn), iron (Fe), cobalt (Co), nickel (Ni), copper (Cu), zinc (Zn), palladium (Pd), platinum (Pt), silver (Ag), gold (Au), mercury (Hg), aluminum (Al), and tin (Sn).

The organic acids from which the metal salts are derived may be either mono-functional or poly-functional. In one embodiment, the organic acids are difunctional. The organic acid can range in size up to 20 carbon atoms and in one embodiment, the organic acid contains four to eight carbon atoms. The organic acid may be either saturated or unsaturated (excluding acrylic or methacrylic acid).

Examples of suitable organic acids include the following, their branched chain isomers, and halogen-substituted derivatives: formic, acetic, propionic, butyric, valeric, caproic, caprylic, carpric, lauric, myristic, palmitic, stearic, oleic, linoleic, linolenic, cyclohexanecarboxylic, phenylacetic, benzoic, *o*-toluic, *m-*toluic, *p*-toluic, *o*-chlorobenzoic, *m*-chlorobenzoic, *p*-chlorobenzoic, *o*-bromobenzoic, *m*-bromobenzoic, *p*-bromobenzoic, *o*-nitobenzoic, *m*-nitrobenzoic, *p-*nitrobenzoic, phthalic, isophthalic, terephthalic, salicylic, *p*-hydroxybenzoic, anthranilic, *m*-aminobenzoic, *p*-aminobenzoic, *o*-methoxybenzoic, *m-*methoxybenzoic, *p*-methoxybenzoic, oxalic, malonic, succinic, glutaric, adipic, pimelic, suberic, azelaic, sebacic, maleic, fumaric, hemimellitic, trimellitic, trimesic, malic, and citric.

Many, if not all, of these carboxylic acids are commercially available or can be readily synthesized by one skilled in the art. The conversion to metal salts is known art, and is accomplished by the methods disclosed in the examples. The metal salts of these carboxylic acids are generally solid materials that can be milled into a fine powder for incorporating into the chosen resin composition. The metal salt will be loaded into the resin composition at a loading of 0.05% to 10% by weight of the formulation. In one embodiment, the loading is around 0.1 % to 0.5% by weight.

Exemplary resins suitable for use in these compositions include phenolics, epoxies, acrylates, maleimides, polyimides, polyurethanes, vinyl chlorides, vinyl acetates, polyesters, silicones, benzox azines, oxetane, thio-ene, oxazolines, nitrones, vinyl ethers, styrenics, and cinnamics. The particular choice of resin is not critical to the invention and the practitioner may choose the resin for curing and adhesive performance as suits the end use application. Such performance characteristics for the resins will be known to those skilled in the art.

The resin composition will also contain a conductive filler. Within this specification and the claims, the words "conductive filler" will be deemed to include (a) a metal in particle, flake, or powder form, and any combination of those, and (b) a nonconductive filler in particle, flake, or powder form, and any combination of those, onto which is coated a metallic surface. The size and shape of the particle, flake and powder are not critical to the invention. In general a combination of flake and powder is used in order to optimize the packing density of the filler. Typically, the conductive filler will be present in an amount from 20% to 95% by weight. In one embodiment, the filler is a silver filler, and is present in an amount from 70% to 90% by weight.

Suitable conductive fillers are metallic and include gold, silver, copper, cobalt, silver coated graphite, copper alloys, platinum, palladium, nickel, aluminum, silver coated copper, silver alloys with platinum or palladium, bronze and brass alloys. The choice of filler composition within the parameters disclosed in this specification for a specific end use application is within the expertise of one skilled in the art and is not critical to obtaining improved conductivity.

### SYNTHETIC EXAMPLES

EXAMPLE 1: Copper Adipate from 1.0 mole adipic acid and 2.1 mole copper (II) nitrate hemipentahydrate. Combined adipic acid (Aldrich, A26357, 99%) (15.0 g, 0.1026 mol) and 100 mL water in a 500 mL, 4-neck round bottom flask equipped with a mechanical mixer, thermometer and pH probe. Reaction yielded a white mixture. With mixing, NH₄OH (assay 28-30%) was added to raise the pH from 2.85 to about (-)7.0. During the add, the reaction temperature was kept at or below 33°C. At about pH 5.2 all solids had dissolved resulting in a clear colorless solution. Stabilized pH to about 7.0. Started cooling the reaction solution to less than or equal to ( </= ) 5°C. Meanwhile, prepared a solution of copper (II) nitrate hemipentahydrate (Aldrich, 223395, 98%) (50.1 g, 0.2154 mol) in 50 mL of water. The salt readily dissolved to a clear dark blue solution. The copper (II) nitrate hemipentahydrate solution was added to the reaction solution while maintaining the reaction temperature </= 6 °C. Immediately upon adding, a turquoise crystalline material precipitated from solution. An exotherm was not observed. After the addition, the turquoise reaction mixture was allowed to sit over night at room temperature. The pH at this point was about 4.2.

After about 12 hours, a fine blue powder was filtered from a clear blue liquor with a pH of ∼3.5. The solids were added to 300 mL of water, mixed for 10 minutes and filtered. This water wash step was repeated. The second water wash was clear and colorless with a pH of ∼6. Following the water washes, the pale blue powder was added to 400 mL of acetone, mixed for 10 minutes and filtered. The acetone wash was clear and colorless.

A pale blue cake of powder was recovered and then dried in a vacuum oven for two days @ 45°C. Approximate yield obtained from the above reaction was 22 grams.

EXAMPLE 2: Copper Adipate from 1.6 mole adipic acid and 1.0 mole copper (II) nitrate hemipentahydrate, Combined adipic acid (Aldrich, A26357, 99%) (50.68 g, 0.3468 mol) and 100 mL water in a 500 mL, 4-neck round bottom flask equipped with a mechanical mixer, thermometer and pH probe. The reaction was a white mixture. With mixing, NH₄OH (assay 28-30%) was added to raise the pH from 2.60 to -7.0. During the add, the reaction temperature was kept at or below 52 °C. At pH 7.0, all solids were dissolved resulting in a clear colorless solution. Stabilized pH - 7.0. Started cooling the reaction solution to </= 10 °C. Meanwhile, prepared a solution of copper (II) nitrate hemipentahydrate (Aldrich, 223395, 98%) (50.0 g, 0.2151 mol) in 50 mL of water. The salt readily dissolved to a clear dark blue solution. Added the copper (II) nitrate hemipentahydrate solution to the reaction solution while maintaining the reaction temperature </= 10 °C. Immediately upon adding, a turquoise crystalline solid precipitated from solution. An exotherm was not observed. After the 20 minute addition, the turquoise reaction mixture was allowed to sit over night at room temperature. The pH at this point was ∼ 6.2.

After about 12 hours, a blue powder was filtered from a clear light blue liquor. The pH of the mother liquor measured ∼5.7 at 30 °C. The solids were added to 250 mL of water, mixed for 10 minutes and filtered. This water wash step was repeated twice more. All water washes were clear and colorless.

Following the water washes, the pale blue powder was added to 400 mL of acetone, mixed for 30 minutes and filtered. The acetone wash was clear and colorless. This step was repeated.

The pale blue cake of powder was dried in a vacuum oven over night @ 45°C. A yield of approximately 47 grams was obtained from the above reaction.

EXAMPLE 3: Copper Adipate from 1.0 mole adipic acid and 1.0 mole copper (II) nitrate hemipentahydrate. Combined adipic acid (Aldrich, A26357, 99%) (29.23 g, 0.2000 mol) and 370 mL water in a 2 L, 4-neck round bottom flask equipped with a magnetic stir bar, thermometer and pH probe. The reaction was a white mixture. With mixing, NH₄OH (assay 28-30%) was added to raise the pH from ∼2.9 to 6.0. The resulting temperature was 30 °C after -27g of NH₄OH had been added. All solids dissolved to a clear colorless solution. Mixed for 15 minutes to insure stabilization of pH ∼ 6.0. Prepared a 370 mL solution of copper (II) nitrate hemipentahydrate (Aldrich, 223395, 98%) (46.50 g, 0.2000 mol) in water. The salt readily dissolved to a clear dark blue solution, which was then charged to a slow-add funnel. While mixing the reaction, the copper (II) nitrate hemipentahydrate solution was essentially dumped in (over 2 minutes). During the course of the add, the pH dropped from ∼6 to ∼4.5 and turquoise solids precipitated from the reaction solution. The temperature did not change (∼26 °C).

Twenty minutes following the add, the turquoise granular mix suddenly changed to a mixture of fine blue solids. At this point, the pH measured 4.2. Within 5 minutes of the color change, the blue solids were filtered as a powder from the clear light blue mother liquor. The solids were added to 500 mL of cold water (<10 °C), mixed for 15 minutes and then filtered. This cold water wash step was repeated three more times. All water washes were clear and nearly colorless. Following the water washes, the blue powder was air dried and then vacuum dried in an oven for -2 days @ 45 °C. A yield of approximately 82% was obtained from the above reaction.

EXAMPLE 4: Silver Adipate from 1.0 mole Adipic acid and 2.06 mole silver nitrate. Combined adipic acid (Aldrich, A26357, 99%) (16.70 g, 0.1143 mol) and 100 mL water in a 250 mL, 4-neck round bottom flask equipped with a mechanical mixer, thermometer and pH probe. The reaction was a white mixture. With mixing, NH₄OH (assay 28-30%) was added to raise the pH to 7.0. The resulting temperature was 33 °C. With the add, all solids dissolved, resulting in a clear colorless solution. Next, while the reaction cooled in an ice bath, a solution of silver nitrate (Aldrich, 209139, 99+%, 40.0 g, 0.2354 mol) was prepared in 40 mL of water. With mixing, the silver nitrate solution was added to the reaction over 30 minutes.

During the add, the reaction temperature was maintained at or below 5°C, the pH dropped to 5.4 and light solids precipitated from the reaction solution. Mixing was continued over night. The solids were then filtered from the reaction mixture, added to 300 mL of water, mixed for 30 minutes and filtered. Following the water wash, the powder product was air dried, mixed in 200 mL of acetone for 30 minutes and then filtered. This acetone wash was repeated two more times. The final filtration yielded a white cake of product, which was air dried, crushed into powder and then vacuum oven dried at 70°C over two days. A yield of approximately 38 grams was obtained from this reaction.

EXAMPLE 5: Silver Adipate from 1.0 mole Adipic acid and 1.03 mole silver nitrate. Combined adipic acid (Aldrich, A26357, 99%) (24.76 g, 0.1694 mol) and 100 mL water in a 250 mL, 4-neck round bottom flask equipped with a mechanical mixer, thermometer and pH probe. The reaction was a white mixture. With mixing, NH₄OH (assay 28-30%) was added to raise the pH to ∼7.0. The resulting temperature was 35 °C. With the add, all solids dissolved, resulting in a clear colorless solution. Next, while the reaction cooled in an ice bath, a solution of silver nitrate (Aldrich, 209139, 99+%, 29.64 g, 0.1745 mol) was prepared in 30 mL of water. With mixing, the silver nitrate solution was added to the reaction over 20 minutes.

During the add, the reaction temperature was maintained below 5 °C, the pH dropped to 6.6 and light solids precipitated from the reaction solution. Mixing was continued for ∼30 minutes. The solids were filtered from the reaction mixture, added to 300 mL of water, mixed for 30 minutes and filtered. Following the water wash, the powder product was air dried, mixed in 200 mL of acetone for 30 minutes and then filtered. This acetone wash was repeated two more times. The final filtration yielded a white cake of product, which was air dried, crushed into powder, and vacuum oven dried at 100°C over night. A yield of 27 grams of white powder was obtained from this reaction.

EXAMPLE 6: Silver succinate from 1.0 mole succinic acid and 1.03 mole silver nitrate. Combined succinic acid (Aldrich, 398055, 99+%) (20.0 g, 0.1694 mol), 100 mL water and 50 mL of methanol in a 250 mL, 4-neck round bottom flask equipped with a mechanical mixer, thermometer and pH probe. The reaction was a white mixture. With mixing, NH₄OH (assay 28-30%) was added to raise the pH from 2.0 to 7.0. With the add, all solids dissolved, resulting in a clear colorless solution. Next, while the reaction cooled in an ice bath, a solution of silver nitrate (Aldrich, 209139, 99+%, 29.64 g, 0.1745 mol) was prepared in 30 mL of water. With mixing, the silver nitrate solution was added to the reaction over 10 minutes.

During the add, the reaction temperature was maintained below 5°C, the pH dropped to 6.5 and white solids precipitated immediately from the reaction solution. Mixing was continued for ∼20 minutes. The solids were then filtered from the reaction mixture, added to 300 mL of water, mixed for 30 minutes and filtered. Following the water wash, the powder product was air dried, mixed in 200 mL of acetone for 30 minutes and then filtered. This acetone wash was repeated two more times. The final filtration yielded a white cake of product, which was air dried, crushed into powder, and vacuum oven dried at 100°C over night. A yield of 26.7 grams of off-white powder was obtained from this reaction.

EXAMPLE 7: Silver succinate from 1.0 mole succinic acid and 2.06 mole silver nitrate. Combined succinic acid (Aldrich, 398055, 99+%) (13.5 g, 0.1143 mol) and 100 mL water in a 250 mL, 4-neck round bottom flask equipped with a mechanical mixer, thermometer and pH probe. The reaction was a white mixture. With mixing, NH₄OH (assay 28-30%) was added to raise the pH from 2.4 to 7.2. With the add, all solids dissolved, resulting in a clear colorless solution. Next, while the reaction cooled in an ice bath, a solution of silver nitrate (Aldrich, 209139, 99+%, 40.0 g, 0.2354 mol) was prepared in 40 mL of water. With mixing, the silver nitrate solution was added to the reaction over 45 minutes while the reaction temperature was maintained at 5°C.

White solids precipitated from the reaction solution immediately upon adding the silver nitrate solution. Mixing was continued for two hours. The solids were then filtered from the reaction mixture, added to 300 mL of water, mixed for 30 minutes and filtered. Following the water wash, the powder product was air dried, mixed in 200 mL of acetone for 30 minutes and filtered. This acetone wash was repeated two more times. The final filtration yielded a white cake of product, which was air dried, crushed into powder, and vacuum oven dried at 100°C over night. A yield of 37 grams of white powder was obtained from this reaction.

EXAMPLE 8: Silver Maliate from 1.0 mole DL-Malic acid and 2.06 mole silver nitrate, Combined D-L malic acid (Aldrich, 240176, 99+%) (15.33 g, 0.1143 mol) and 100 mL water in a 250 mL, 4-neck round bottom flask equipped with a mechanical mixer, thermometer and pH probe. The reaction was a clear and colorless solution. With mixing, NH₄OH (assay 28-30%) was added to raise the pH from 1.8 to 7.2. Upon neutralizing, the resulting reaction temperature reached 34 °C. Next, while the reaction cooled in an ice bath, a solution of silver nitrate (Aldrich, 209139, 99+%, 40.0 g, 0.2354 mol) was prepared in 40 mL of water. With mixing, the silver nitrate solution was added to the reaction over 25 minutes while the reaction temperature was maintained at 5°C.

White solids precipitated from the reaction solution immediately upon adding the silver nitrate solution. Mixing was continued for 2 hours. The solids were then filtered from the reaction mixture, added to 300 mL of water, mixed for 30 minutes and filtered. Following the water wash, the product was air dried, mixed in 200 mL of acetone for 30 minutes and filtered. This acetone wash was repeated two more times. The final filtration yielded a white cake of product, which was air dried, crushed into powder, and vacuum oven dried at 70°C for two days. A yield of 37 grams of white powder was obtained from this reaction.

EXAMPLE 9: Silver Maleate from 1.0 mole Maleic acid and 2.06 mole silver nitrate. Combined maleic acid (Aldrich, M153, 99%) (13.27 g, 0.1143 mol) and 100 mL water in a 250 mL, 4-neck round bottom flask equipped with a mechanical mixer, thermometer and pH probe. The reaction was a clear and colorless solution. With mixing, NH₄OH (assay 28-30%) was added to raise the pH from 1.2 to 7.0. Upon neutralizing, the resulting reaction temperature reached 37°C. Next, while the reaction cooled in an ice bath, a solution of silver nitrate (Aldrich, 209139, 99+%, 40.0 g, 0.2354 mol) was prepared in 40 mL of water. With mixing, the silver nitrate solution was added to the reaction over 70 minutes while the reaction temperature was maintained between 4° and 6°C.

White solids precipitated from the reaction solution immediately upon adding the silver nitrate solution. Mixing was continued for one hour. The solids were then filtered from the reaction mixture, added to 300 mL of water, mixed for 30 minutes and filtered. Following the water wash, the product was air dried, mixed in 200 mL of acetone for 30 minutes and then filtered. This acetone wash was repeated three more times. The final filtration yielded a tan cake of product which was air dried, crushed into powder, and vacuum oven dried at 70°C for two days. A yield of 31 grams of light tan powder was obtained from this reaction.

### PERFORMANCE EXAMPLES

EXAMPLE 10: Bismaleimde and Epoxy formulations. Two formulations, A and B were prepared, each containing 23 parts by weight of resin system and 77 parts by weight of silver flake. A major portion of the resin system comprised bismaleimide and epoxy resins and a minor portion comprised curing agent, catalyst, adhesion promoter and diluent. Formulation A contained no metal salt of organic acid; Formulation B contained 0.5 parts by weight of silver adipate (with a proportionate amount of the resin system components decreased by 0.5 parts by weight). The Formulations were tested for volume resistivity (VR) and for bond joint resistivity (BJR). Test protocols are given at the end of the Examples. The results are reported in Table 1.

| TABLE 1. RESISTIVITY FOR BISMALEIMIDE/EPOXY FORMULATION | | |
|---|---|---|
| OVEN CURE | FORMULATION A | FORMULATION B |
| VR (ohm.cms) | 0.12 | 0.0004 |
| BJR (ohms) | 7.5 | 0.0023 |

| SNAP CURE | FORMULATION A | FORMULATION B |
|---|---|---|
| VR (ohm.cms) | 0.05 | 0.00009 |
| BJR (ohms) | 0.67 | 0.0069 |

The results show that the addition of the metal salt of an organic acid significantly improves the conductivity of a resin composition filled with a conductive filler.

EXAMPLE 11: Bismaleimide and Acrylate Formulation. Two formulations, C and D were prepared, each containing 20 parts by weight of resin system and 80 parts by weight of silver flake. A major portion of the resin system comprised bismaleimide, acrylate, and epoxy resins, and a minor portion comprised curing agent, catalyst, adhesion promoter and diluent. Formulation C contained no metal salt of organic acid; Formulation D contained 0.5 parts by weight of copper adipate (with a proportionate amount of the resin system components decreased by 0.5 parts by weight). The Formulations were tested for volume resistivity (VR) and for bond joint resistivity (BJR). Test protocols are given at the end of the Examples. The results are reported in Table 2.

**TABLE 2. RESISTIVITY OF BISMALEIMIDE AND ACRYLATE FORMULATION**

| OVEN CURE | FORMULATION C | FORMULATION D |
|---|---|---|
| VR (ohm.cms) | 0.0002 | 0.00003 |
| BJR (ohms) | 0.0035 | 0.0008 |
| | | |

| SNAP CURE | FORMULATION C | FORMULATION D |
|---|---|---|
| VR (ohm.cms) | 0.0007 | 0.00005 |
| BJR (ohms) | 0.0084 | 0.0006 |

The results show that the addition of the metal salt of an organic acid significantly improves the conductivity of a resin composition filled with a conductive filler.

EXAMPLE 12: EPOXY FORMULATION. Two formulations, E and F were prepared, each containing 23 parts by weight of resin system and 77 parts by weight of silver flake. A major portion of the resin system comprised bismaleimide and epoxy resins and a minor portion comprised curing agent, catalyst, adhesion promoter and diluent. Formulation A contained no metal salt of organic acid; Formulation B contained 0.5 parts by weight of copper adipate (with a proportionate amount of the resin system components decreased by 0.5 parts by weight). The Formulations were tested for volume resistivity (VR) and for bond joint resistivity (BJR). Test protocols are given at the end of the Examples. The results are reported in Table 3.

| TABLE 3. RESISTIVITY OF EPOXY FORMULATION | | |
|---|---|---|
| OVEN CURE | FORMULATION E | FORMULATION F |
| VR (ohm.cms) | >50 | 0.00027 |
| BJR (ohms) | 0.85 | 0.0065 |

The results show that the addition of the metal salt of an organic acid significantly improves the conductivity of a resin composition filled with a conductive filler.

### TEST PROTOCOLS

VOLUME RESISTIVITY: Volume resistivity (VR) is defined as the ratio of the dc voltage drop per unit thickness to the amount of current per unit area passing through the material being tested. A basic material property, volume resistivity indicates how readily a material conducts electricity through the bulk of the material and is expressed in ohm-centimeters (Ω-cm). Volume resistivity for the samples within this specification was tested on a Quadtech Digibridge or a Keithley Sourcemeter 4 on cured samples 3 mm (width) by 0.05 mm (height) by 25 mm (length). Two different operators conducted the testing on two different measurement devices (Quadtech and Keithley), with five repeats of each specimen. The percent variation on this test was less than 5%. Oven cured specimens were brought to 175°C over 30 minutes, then held at 175°C for 15 minutes. Snap cured specimens were cured under nitrogen at 120°C for 15 seconds, then at 150°C for 15 seconds, then at 180°C for 15 seconds, then at 200°C for 15 seconds, and finally at 220°C for 60 seconds.

BOND JOINT RESISTANCE. Bond joint resistance (BJR) is the measure of electrical resistance across the bond line in conductive material joints. BJR measurements were conducted on a Keithley Sourcemeter set in delta mode, in conjunction with a Keithley nanovolt meter in delta mode. Conductive material was dispensed and screen printed on silver plated 6mm x 6mm bond pads to a thickness of 1 mil (25 microns), then oven cured as for VR.

## Claims

1. Use of a metal salt of an organic acid as conductivity promoter, excluding the metal salts of acrylic or methacrylic acids, in a conductive resin composition comprising resin and a conductive filler.

2. Use according to claim 1 in which the organic acids from which the metal salt of an organic acid is derived are selected from the group consisting of: formic, acetic, propionic, butyric, valeric, caproic, caprylic, carpric, lauric, myristic, palmitic, stearic, oleic, linoleic, linolenic, cyclohexanecarboxylic, phenylacetic, benzoic, *o*-toluic, *m*-toluic, *p*-toluic, *o*-chlorobenzoic, *m*-chlorobenzoic, *p*-chlorobenzoic, *o*-bromobenzoic, *m*-bromobenzoic, *p*-bromobenzoic, *o*-nitobenzoic, *m*-nitrobenzoic, *p*-nitrobenzoic, phthalic, isophthalic, terephthalic, salicylic, *p*-hydroxybenzoic, anthranilic, *m*-aminobenzoic, *p*-aminobenzoic, *o*-methoxybenzoic, *m*-methoxybenzoic, *p-*methoxybenzoic, oxalic, malonic, succinic, glutaric, adipic, pimelic, suberic, azelaic, sebacic, maleic, fumaric, hemimellitic, trimellitic, trimesic, malic, citric, and their branched chain isomers, and halogen-substituted derivatives.

3. Use according to claim 1 in which the metals from which the metal salts of organic acids are derived are selected from the group consisting of lithium (Li), sodium (Na), magnesium (Mg), potassium (K), calcium (Ca), scandium (Sc), titanium (Ti), vanadium (V), chromium (Cr), manganese (Mn), iron (Fe), cobalt (Co), nickel (Ni), copper (Cu), zinc (Zn), palladium (Pd), platinum (Pt), silver (Ag), gold (Au), mercury (Hg), aluminum (Al), and tin (Sn).

4. Use according to claim 1 in which the resin is selected from the group consisting of phenolics, epoxies, acrylates, maleimides, polyimides, polyurethanes, vinyl chlorides, vinyl acetates, polyesters, silicones, benzoxazines, oxetane, thio-ene, oxazolines, nitrones, vinyl ethers, styrenics, and cinnamics.

5. Use according to claim 4 in which the resin is selected from the group consisting of epoxies, bismaleimides, acrylates and a combination of those.

6. Use according to claim 1 in which the conductive filler is selected from the group consisting of gold, silver, copper, cobalt, silver coated graphite, copper alloys, platinum, palladium, nickel, aluminum, silver coated copper, silver alloys with platinum or palladium, bronze and brass alloys.

## Patentansprüche

1. Verwendung eines Metallsalzes einer organischen Säure als Leitfähigkeitspromotor, ausgenommen die Metallsalze von Acryl- oder Methacrylsäure, in einer leitfähigen Harzzusammensetzung, die ein Harz und einen leitfähigen Füllstoff umfasst.

2. Verwendung nach Anspruch 1, wobei die organischen Säuren, von denen das Metallsalz einer organischen Säure abgeleitet ist, ausgewählt sind aus der Gruppe, bestehend aus: Ameisensäure, Essigsäure, Propionsäure, Buttersäure, Valeriansäure, Capronsäure, Caprylsäure, Caprinsäure, Laurinsäure, Myristinsäure, Palmitinsäure, Stearinsäure, Ölsäure, Linolsäure, Linolensäure, Cyclohexancarbonsäure, Phenylessigsäure, Benzoesäure, o-Tolylsäure, m-Tolylsäure, p-Tolylsäure, o-Chlorbenzoesäure, m-Chlorbenzoesäure, p-Chlorbenzoesäure, o-Brombenzoesäure, m-Brombenzoesäure, p-Brombenzoesäure, o-Nitrobenzoesäure, m-Nitrobenzoesäure, p-Nitrobenzoesäure, Phthalsäure, Isophthalsäure, Terephthalsäure, Salicylsäure, p-Hydroxybenzoesäure, Anthranilsäure, m-Aminobenzoesäure, p-Aminobenzoesäure, o-Methoxybenzoesäure, m-Methoxybenzoesäure, p-Methoxybenzoesäure, Oxalsäure, Malonsäure, Bernsteinsäure, Glutarsäure, Adipinsäure, Pimelinsäure, Suberinsäure, Azelainsäure, Sebacinsäure, Maleinsäure, Fumarsäure, Hemimellithsäure, Trimellithsäure, Trimesinsäure, Äpfelsäure, Citronensäure und ihren verzweigtkettigen Isomeren und Halogen-substituierten Derivaten.

3. Verwendung nach Anspruch 1, wobei die Metalle, von denen die Metallsalze von organischen Säuren abgeleitet sind, ausgewählt sind aus der Gruppe, bestehend aus Lithium (Li), Natrium (Na), Magnesium (Mg), Kalium (K), Calcium (Ca), Scandium (Sc), Titan (Ti), Vanadium (V), Chrom (Cr), Mangan (Mn), Eisen (Fe), Kobalt (Co), Nickel (Ni), Kupfer (Cu), Zink (Zn), Palladium (Pd), Platin (Pt), Silber (Ag), Gold (Au), Quecksilber (Hg), Aluminium (Al) und Zinn (Sn).

4. Verwendung nach Anspruch 1, wobei das Harz ausgewählt ist aus der Gruppe, bestehend aus Phenolharzen, Epoxiden, Acrylaten, Maleimiden, Polyimiden, Polyurethanen, Vinylchloriden, Vinylacetaten, Polyestern, Siliconen, Benzoxazinen, Oxetan, Thioen, Oxazolinen, Nitronen, Vinylethern, Styrolharzen und Cinnamics.

5. Verwendung nach Anspruch 4, wobei das Harz ausgewählt ist aus der Gruppe, bestehend aus Epoxiden, Bismaleimiden, Acrylaten und einer Kombination von solchen.

6. Verwendung nach Anspruch 1, wobei der leitfähige Füllstoff ausgewählt ist aus der Gruppe, bestehend aus Gold, Silber, Kupfer, Kobalt, mit Silber überzogenem Graphit, Kupferlegierungen, Platin, Palladium, Nickel, Aluminium, mit Silber überzogenem Kupfer, Silberlegierungen mit Platin oder Palladium, Bronze- und Messing-Legierungen.

## Revendications

1. Utilisation d'un sel métallique d'un acide organique en tant que promoteur de conductivité, à l'exclusion des sels métalliques d'acides acryliques ou méthacryliques, dans une composition de résine conductrice comprenant une résine et une charge conductrice.

2. Utilisation selon la revendication 1, dans laquelle les acides organiques dont le sel métallique d'un acide organique est dérivé sont choisis dans l'ensemble constitué des acides formique, acétique, propionique, butyrique, valérique, caproïque, caprylique, caprique, laurique, myristique, palmitique, stéarique, oléique, linoléique, linolénique, cyclohexanecarboxylique, phénylacétique, benzoïque, *o*-toluique, *m*-toluique, *p-*toluique, *o*-chlorobenzoïque, *m*-chlorobenzoïque, *p-*chlorobenzoïque, *o*-bromobenzoïque, *m*-bromobenzoïque, *p-*bromobenzoïque, *o*-nitrobenzoïque, *m*-nitrobenzoïque, *p-*nitrobenzoïque, phtalique, isophtalique, téréphtalique, salicylique, *p*-hydroxybenzoïque, anthranilique, *m-*aminobenzoïque, *p*-aminobenzoïque, *o*-méthoxybenzoïque, *m-*méthoxybenzoïque, *p*-méthoxybenzoïque, oxalique, malonique, succinique, glutarique, adipique, pimélique, subérique, azélaïque, sébacique, maléique, fumarique, hémimellique, trimellique, trimésique, malique, citrique et leurs isomères à chaîne ramifiée et des dérivés substitués par un halogène.

3. Utilisation selon la revendication 1, dans laquelle les métaux dont les sels métalliques d'acides organiques sont dérivés sont choisis dans l'ensemble constitué de lithium (Li), sodium (Na), magnésium (Mg), potassium (K), calcium (Ca), scandium (Sc), titane (Ti), vanadium (V), chrome (Cr), manganèse (Mn), fer (Fe), cobalt (Co), nickel (Ni), cuivre (Cu), zinc (Zn), palladium (Pd), platine (Pt), argent (Ag), or (Au), mercure (Hg), aluminium (Al) et étain (Sn).

4. Utilisation selon la revendication 1, dans laquelle la résine est choisie dans l'ensemble constitué de résines phénoliques, époxy, acrylates, maléimides, polyimides, polyuréthannes, chlorures de vinyle, acétates de vinyle, polyesters, silicones, benzoxazines, oxétanne, thio-ène, oxazolines, nitrones, éthers de vinyle, composés styréniques et composés cinnamiques.

5. Utilisation selon la revendication 4, dans laquelle la résine est choisie dans l'ensemble constitué de composés époxy, bismaléimides, acrylates et d'une combinaison de ceux-ci.

6. Utilisation selon la revendication 1, dans laquelle la charge conductrice est choisie dans l'ensemble constitué de l'or, l'argent, le cuivre, le cobalt, le graphite revêtu d'argent, des alliages de cuivre, le platine, le palladium, le nickel, l'aluminium, le cuivre revêtu d'argent, des alliages d'argent avec du platine ou du palladium, le bronze et des alliages de laiton.
